# DEMANDE DE BREVET EUROPEEN

(11) **EP 3 696 151 A1**
(43) Date de publication de la demande: **19.08.2020**
(21) Numéro de dépôt: 19157748.5
(22) Date de dépôt: 18.02.2019
(51) Int. Cl.: C03C 4/02, C03C 14/00, C03C 21/00, G04B 1/00, C30B 31/00, C30B 33/02

(54) **GLACE DE MONTRE COLORÉE**

(71) Demandeur: ROLEX SA, 1211 Genève 26 (CH)
(72) Inventeur: Borges-Machado, Maria-Isabel, 1226 Thônex (CH); Roulet, Alexandra, 1211 Genève 26 (CH)
(74) Mandataire: Moinas & Savoye SARL

(57) **Abrégé**

Composant horloger transparent, notamment glace de montre, caractérisé en ce qu'il comprend une surface intérieure sensiblement plane ou courbée, et en ce qu'il comprend principalement un matériau transparent, coloré par une zone de composition chimique modifiée au sein dudit composant par un apport d'au moins un élément chimique colorant audit matériau transparent, cette zone de composition chimique modifiée s'étendant dans une partie seulement de l'épaisseur totale du composant horloger.

## Description

### Introduction

La présente invention concerne un composant horloger transparent et coloré, notamment une glace de montre. L'invention porte aussi sur une pièce d'horlogerie, comme une montre, comprenant un tel composant horloger. Elle porte aussi sur un procédé de fabrication d'un composant horloger, comprenant particulièrement une phase de coloration d'un substrat transparent.

### Etat de l'Art

Une glace de montre en saphir est par nature transparente et incolore, et il est parfois souhaité de modifier son apparence pour la rendre colorée. Pour cela, il existe un procédé pour synthétiser le saphir en le colorant simultanément. Ce procédé produit une boule de saphir, colorée dans la masse, dans laquelle des glaces de montre sont ensuite découpées. Un tel procédé est, par exemple, décrit dans le document WO2017187647. Cette solution de l'état de la technique présente de nombreux inconvénients :
- elle nécessite une étude complexe lors de chaque changement de couleur ;
- elle ne permet pas de colorer partiellement le composant, ni de combiner plusieurs couleurs ;
- elle n'est pas compatible avec certaines couleurs, qui ne peuvent pas être obtenues, ou avec un rendu de qualité insuffisante ; elle peut donc être incompatible avec une application horlogère.

En complément des remarques précédentes, il convient de préciser que tout procédé de fabrication d'un composant horloger doit respecter de nombreuses contraintes et que la modification d'un procédé pour intégrer une étape de coloration ne doit pas dégrader la qualité globale du composant horloger obtenu. Par exemple, dans le cas d'une glace de montre, les exigences horlogères suivantes doivent être respectées :
- La glace doit présenter une transparence suffisante pour permettre la lecture de l'heure ;
- La glace doit présenter une grande résistance mécanique globale, ainsi qu'une résistance de surface aux rayures ;
- La coloration d'une telle glace doit permettre d'atteindre un résultat prévisible et répétable ;
- La couleur perçue doit présenter un rendu de qualité, sans défaut, avec une parfaite homogénéité ou avec une répartition hétérogène précise selon un choix prédéfini ;
- La couleur obtenue doit être adaptée à la montre, notamment au cadran qui sera visible au travers de la glace.

Cette problématique technique s'applique aussi à d'autres composants horlogers transparents, notamment présentant une forme sensiblement plane, en particulier présentant une surface intérieure sensiblement plane ou courbée et/ou se présentant dans une matière minérale, comme le saphir ou le verre.

L'invention a pour objectif général d'offrir une solution pour obtenir un composant horloger transparent et coloré, qui ne comprend pas tout ou partie des inconvénients de l'état de la technique.

Plus particulièrement, un objet de l'invention est d'offrir une solution de composant horloger transparent et coloré, permettant d'atteindre un aspect visuel répétable et précis, de grande qualité.

### Brève description de l'invention

A cet effet, l'invention repose sur un composant horloger transparent, notamment glace de montre, caractérisé en ce qu'il comprend une surface intérieure sensiblement plane ou courbée, et en ce qu'il comprend principalement un matériau transparent, coloré par une zone de composition chimique modifiée au sein dudit composant par un apport d'au moins un élément chimique colorant audit matériau transparent, cette zone de composition chimique modifiée s'étendant dans une partie seulement de l'épaisseur totale du composant horloger. Avantageusement, cette zone de composition chimique modifiée ne s'étend pas dans tout le volume du composant horloger. Avantageusement encore, elle ne s'étend pas sur toute son épaisseur. Avantageusement encore, elle s'étend sur une faible partie de son épaisseur et/ou de son volume.

L'invention porte aussi sur un procédé de fabrication d'un composant horloger coloré et transparent, caractérisé en ce qu'il comprend les étapes suivantes :
a. Mise à disposition d'un substrat initial qui comprend une surface intérieure sensiblement plane ou courbée composé principalement d'un matériau transparent ;
b. Apport d'au moins un élément chimique colorant par au moins une surface extérieure ou intérieure dudit substrat initial ;
c. Traitement thermique dudit substrat issu de l'étape d'apport comprenant au moins un élément chimique colorant pour obtenir une pièce transparente et colorée.

Avantageusement, l'étape d'apport comprend le dépôt d'un revêtement comprenant le au moins un élément chimique colorant.

L'invention est plus précisément définie par les revendications.

### Brève description des figures

Ces objets, caractéristiques et avantages de l'invention, seront exposés en détail dans la description suivante d'un mode de réalisation particulier fait à titre non-limitatif en relation avec les figures jointes parmi lesquelles :
Les figures 1a à 1e représentent schématiquement des vues en coupe dans l'épaisseur de substrats préfigurant des composants horlogers, selon plusieurs variantes du mode de réalisation de l'invention.
Les figures 2a et 2b représentent schématiquement des vues en coupe dans l'épaisseur d'un substrat préfigurant un composant horloger, respectivement après mise en oeuvre d'une première étape de fabrication puis d'une deuxième étape de fabrication du procédé de fabrication selon le mode de réalisation de l'invention.
La figure 3a représente une comparaison de la transmittance (T) en fonction de la longueur d'onde (L) de différentes glaces en saphir selon un premier exemple, obtenues par différentes variantes du procédé de fabrication selon le mode de réalisation de l'invention.
La figure 3b est un agrandissement de la figure précédente.
La figure 3c représente une image prise au Microscope Électronique à Transmission (MET) sur une lame mince prélevée sur une pièce transparente colorée à l'issue de la mise en oeuvre du procédé de fabrication selon le mode de réalisation de l'invention. Un encart représente un cliché de diffraction électronique acquis dans la zone proche de la surface (à une distance de la surface inférieure à la distance d).
La figure 4 représente la transmittance (T) en fonction de la longueur d'onde (L) de différentes glaces saphir selon un deuxième exemple, obtenues par différentes variantes du procédé de fabrication selon le mode de réalisation de l'invention.
La figure 5 représente la transmittance (T) en fonction de la longueur d'onde (L) de différentes glaces saphir selon un troisième exemple, obtenues par différentes variantes du procédé de fabrication selon le mode de réalisation de l'invention.
Les figures 6a à 6c représentent la transmittance (T) en fonction de la longueur d'onde (L) de différentes glaces saphir selon un quatrième exemple, obtenues par différentes variantes du procédé de fabrication selon le mode de réalisation de l'invention.
La figure 7 représente les spectres de transmittance (T) en fonction de la longueur d'onde (L) de différentes glaces saphir selon un cinquième exemple, obtenues par différentes variantes du procédé de fabrication selon le mode de réalisation de l'invention.

Pour la fluidité de la description, nous utiliserons les mêmes références pour les différentes variantes de réalisation pour désigner des caractéristiques identiques ou équivalentes.

De plus, pour simplifier la description suivante, nous désignerons par l'adjectif « extérieur » un volume ou une surface d'un composant horloger destiné à une orientation vers l'extérieur d'une pièce d'horlogerie, notamment incluant un volume ou une surface directement visible par un observateur de la pièce d'horlogerie. Au contraire, l'adjectif « intérieur » désignera un volume ou une surface d'un composant horloger destiné à une orientation vers l'intérieur d'une pièce d'horlogerie. De manière abusive, nous étendrons l'utilisation des adjectifs « extérieur » et « intérieur » à un composant qui serait intégralement disposé à l'intérieur d'une pièce d'horlogerie, sa surface extérieure étant alors celle qui serait positionnée la plus proche de la limite extérieure de la pièce d'horlogerie.

D'autre part, nous utiliserons l'adjectif « transparent » pour désigner la propriété d'un matériau dès lors que le matériau considéré entraîne une transmission, évaluée par le facteur de transmission Y, supérieur à 68% inclus, voire supérieur à 79% inclus, d'un rayonnement lumineux comprenant au moins des longueurs d'onde du visible. Par « matériau transparent », nous considérons un matériau dont la nature, combinée à l'épaisseur utilisée, permet la transmission au moins partielle du rayonnement lumineux précité. Avantageusement, le matériau transparent utilisé permet aussi une transmission au moins partielle de rayonnements comprenant des longueurs d'onde des ultraviolets.

Nous allons maintenant décrire un mode de réalisation de l'invention d'un procédé de fabrication d'une glace saphir de pièce d'horlogerie. Ce même procédé sera applicable à d'autres composants horlogers, comme cela sera détaillé par la suite. Ce procédé de fabrication comprend les deux étapes principales suivantes, qui forment une phase de coloration ou un procédé de coloration, suite à une étape préalable de mise à disposition E0 d'un substrat transparent, c'est-à-dire comprenant principalement un matériau transparent :
- Apport E1 d'au moins un élément chimique colorant sur au moins une surface extérieure ou intérieure dudit substrat, autrement appelé substrat initial, mis à disposition ;
- Traitement thermique E2 dudit substrat issu de l'étape d'apport comprenant l'au moins un élément chimique colorant pour obtenir une pièce transparente et colorée.

Comme mentionné ci-dessus, le procédé met en oeuvre une étape préalable de mise à disposition E0 d'un substrat initial 10. Ce substrat se présente avantageusement selon une forme sensiblement plane, comprenant une surface extérieure, destinée à une orientation vers l'extérieur d'une pièce d'horlogerie, et une surface intérieure sensiblement plane ou courbée, destinée à une orientation vers l'intérieur d'une pièce d'horlogerie. Ce substrat se présente avantageusement intégralement dans un matériau transparent. Ce matériau transparent peut être incolore. En variante, il peut être coloré. Le procédé pourrait toutefois s'appliquer sur une portion transparente d'un substrat qui ne serait que localement transparent.

Dans le mode de réalisation, le matériau transparent est du saphir, plus précisément une alumine synthétique monocristalline. En variante, le matériau pourrait être tout autre matériau transparent composé au moins partiellement de matière inorganique et/ou minérale, comme du verre (borosilicate, photostructurable, ...), du corindon, de l'alumine, du grenat d'yttrium et d'aluminium (YAG), de la vitrocéramique et/ou de la céramique mono ou polycristalline. Le matériau transparent peut également être de l'alumine colorée ou tout autre matériau transparent précité préalablement coloré.

Le substrat initial présente de plus avantageusement une forme identique à celle de la future glace, voire une forme proche, qui pourra être modifiée par des étapes ultérieures, par exemple un usinage. Le substrat présente de plus avantageusement un état de surface identique à celui de la future glace. Sa surface extérieure et/ou intérieure est de préférence polie. En variante, elle peut présenter un autre état de surface, notamment localement.

La surface extérieure et/ou intérieure peut être plane. En variante, elle peut être courbée, par exemple concave ou convexe. Elle peut être courbée et de préférence continue, c'est-à-dire non composée de facettes juxtaposées. Elle peut toutefois comprendre un biseau ou un chanfrein, notamment au niveau de sa partie périphérique, comme cela sera détaillé par la suite.

En variante, au moins une surface intérieure ou extérieure peut comprendre des motifs, pouvant notamment figurer des indications horaires ou dérivées de l'heure, par exemple usinés, formant des zones structurées en relief et/ou en retrait.

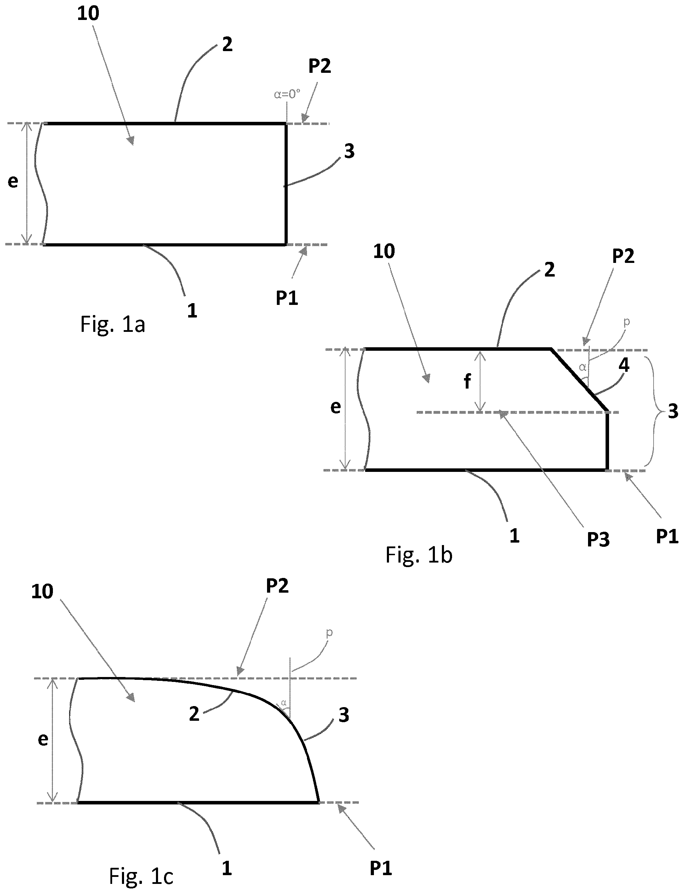

Les figures 1a à 1e illustrent des exemples de substrats, appelés substrats initiaux, proposés dans une étape préalable, en vue de fabriquer une glace de montre, selon plusieurs variantes de réalisation.

La figure 1a représente ainsi un substrat initial 10 selon une première variante comprenant une surface extérieure 2 plane formant un plan P2, parallèle à une surface intérieure 1 plane formant un plan P1. Le substrat comprend de plus en périphérie un flanc 3, formant une troisième surface cylindrique plane qui s'étend de la surface extérieure 2 à la surface intérieure 1, perpendiculairement à ces deux surfaces, sur tout le pourtour du substrat. L'épaisseur totale e du substrat initial est définie comme la distance entre la surface extérieure 2 et la surface intérieure 1. Notamment, l'épaisseur totale e est mesurée perpendiculairement à la surface intérieure 1 selon une direction p perpendiculaire au plan P1, notamment aux plans P1, P2. Le substrat peut bien entendu présenter toute forme, correspondant avantageusement à la future pièce d'horlogerie sur laquelle il sera monté, par exemple circulaire, ellipsoïdale, rectangulaire, etc. Il présente avantageusement une surface intérieure dotée d'une superficie supérieure ou égale à 20 mm², en vue de la fabrication d'un cyclope ou d'une loupe, ou supérieure ou égale à 80 mm², voire supérieure ou égale à 200 mm², voire supérieure ou égal à 300 mm², en vue de la fabrication d'une glace de montre.

La figure 1b représente un substrat initial 10 selon une deuxième variante, qui se différencie du substrat de la première variante en ce que le flanc 3 comprend une partie 4 formant un biseau, agencée en périphérie de sa surface extérieure 2. Cette partie 4 biseautée est tronconique et s'étend entre la surface extérieure 2 et le reste du flanc 3 (entre le plan P2 et un plan intermédiaire P3 parallèle au plan P2). Le reste du flanc 3 est toujours perpendiculaire à la surface intérieure 1. Avantageusement, cette partie biseautée s'étend sur tout le pourtour du substrat. La partie 4 biseautée s'étend sur une épaisseur f du substrat, mesurée perpendiculairement aux plans P2, P3, qui correspond sensiblement à un peu moins de la moitié de l'épaisseur totale e du substrat. De préférence, l'épaisseur f est comprise entre 0.07 et 0.6 fois l'épaisseur totale e du substrat. La partie 4 biseautée forme un angle α constant avec la direction p. Avantageusement, l'angle α est compris entre 30° et 80°. Alternativement, l'angle α et/ou l'épaisseur f pourraient varier sur la circonférence de la glace.

La figure 1c représente un substrat initial 10 selon une troisième variante, qui forme une solution intermédiaire entre les deux variantes précédentes. Le flanc 3 au moins en partie plan est remplacé par un flanc 3 courbé, qui relie les deux surfaces extérieure et intérieure par une courbe continue. La courbe formant le flanc 3 peut être caractérisée en chaque point par un angle α défini par l'angle entre la tangente de ladite courbe et la direction p. Cet angle α est variable, mais reste supérieur à 30° sur une première partie du flanc 3, du côté de la surface extérieure 2. Le reste de la courbe formant le flanc 3, du côté de la surface intérieure 1, peut être perpendiculaire ou sensiblement perpendiculaire à la surface intérieure 1, avec un angle α égal à 0° ou tendant vers 0°. Cette première partie du flanc 3 s'apparente à la surface biseautée 4 de la deuxième variante.

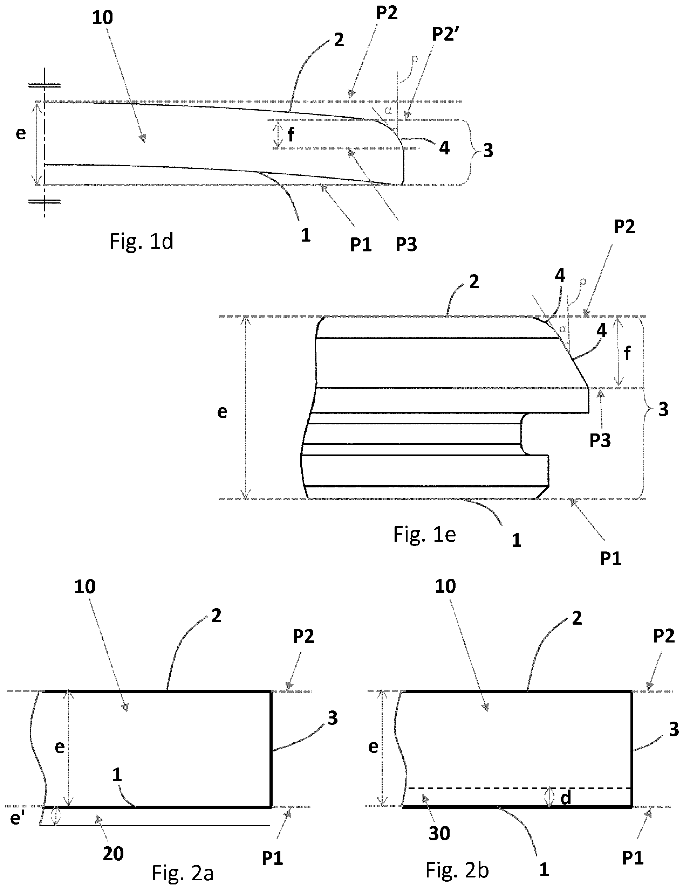

La figure 1d représente un substrat initial 10 selon une quatrième variante, dans laquelle les deux surfaces extérieure 2 et intérieure 1 sont courbées, selon une même forme parallèle. La paroi extérieure est symétriquement agencée autour d'un axe central et on définit le sommet comme étant le point le plus à l'extérieur de la surface extérieure 2, et le plan P2 comme le plan tangent à cette surface extérieure 2 courbée et passant au niveau de ce sommet. Le plan P2 correspond ainsi au plan le plus à l'extérieur de la surface extérieure 2. De même, les points les plus à l'intérieur de la surface intérieure 1, c'est à dire les points définissant la périphérie de la surface intérieure, peuvent définir un plan P1 tangent à la surface intérieure 1, et qui est parallèle au plan P2. La direction p est définie comme la direction perpendiculaire au plan P1, notamment aux plans P1, P2. L'épaisseur totale e du substrat reste alors définie comme la distance entre les deux plans P1, P2, l'épaisseur totale e étant mesurée perpendiculairement au plan P1, selon la direction p. Le flanc 3 constitue la surface périphérique qui relie les deux surfaces. Ce flanc 3 comprend une première partie 4 courbée, au niveau de la surface extérieure 2, prolongée par une partie perpendiculaire aux plans P1, P2 jusqu'à la surface intérieure 1. La première partie courbée 4 s'étend globalement entre des plans P2' et P3, parallèles aux plans P1, P2, et présente une épaisseur f, mesurée perpendiculairement aux plans P2', P3, strictement inférieure à l'épaisseur totale e. Alternativement, un substrat avec une surface intérieure 1 plane et des critères géométriques par ailleurs équivalents à ceux de la figure 1d, peut être envisagé.

La figure 1e représente un substrat initial 10 selon une cinquième variante, dans laquelle les deux surfaces extérieure 2 et intérieure 1 sont planes et parallèles. Le flanc 3 comprend une première partie correspondant à un biseau 4, semblable à celui de la deuxième variante, et une deuxième partie comprenant une gorge. Ce flanc comprend de plus quelques angles arrondis.

Dans tous les cas, l'épaisseur totale e du substrat initial 10, et donc de la glace de montre, est comprise entre 0.2 mm et 15 mm, voire entre 0.85 mm et 15 mm, voire entre 1.45 mm et 11 mm. De plus, quelles que soient les configurations géométriques de la glace, un angle α d'un flanc 3, supérieur ou égal à 10°, préférentiellement supérieur ou égal à 15°, voire supérieur ou égal à 30°, permettra d'atteindre un effet visuel de modulation de la coloration. De plus, quelles que soient les configurations géométriques de la glace, la partie 4 particulière du flanc 3 peut présenter une superficie variable par rapport à la superficie de la surface intérieure 1, et peut représenter de 1% à 30% de cette surface intérieure 1, voire entre 1% et 18%, voire préférablement entre 10% et 18% de cette surface intérieure 1.

Lorsque le substrat est mis à disposition à l'issue de cette étape préalable, le procédé de fabrication met alors en oeuvre les deux étapes principales du procédé, qui forment une phase de coloration du substrat initial.

La première étape consiste à apporter E1 au moins un élément chimique colorant.

Selon une première variante de réalisation, cet apport est réalisé par le dépôt d'un revêtement comprenant l'au moins un élément chimique colorant sur au moins une des deux surfaces intérieure ou extérieure du substrat initial. Pour cela, ce revêtement peut être déposé par l'un des procédés suivants :
- Un dépôt physique en phase vapeur (PVD), et particulièrement une pulvérisation cathodique magnétron (MS pour Magnetron Sputtering) ; ou
- Un dépôt physique en phase vapeur (PVD), et particulièrement une évaporation thermique ; ou
- Un dépôt chimique en phase vapeur (CVD) ; ou
- Un dépôt en couche atomique (ALD pour Atomic Layer Deposition) ; ou
- Un dépôt en phase liquide de type spin-coating, dip-coating ou sol-gel.

Selon une deuxième variante de réalisation, cet apport est réalisé par implantation ionique par recul, notamment dans le cas où la diffusion dans le substrat de l'élément chimique colorant apporté sous forme de revêtement est lente ou nécessite une température trop élevée. Par « implantation ionique par recul », il est entendu un dépôt d'un revêtement mince composé de l'au moins un élément chimique colorant par PVD, CVD et/ou ALD, combiné à une implantation ionique dudit revêtement par bombardement par un gaz tel que l'argon et/ou l'azote et/ou l'oxygène.

Dans ces variantes d'apport d'au moins un élément chimique colorant, un revêtement est réalisé sur au moins une des surfaces du substrat initial, notamment sur au moins une des surfaces extérieure ou intérieure. Ce revêtement peut être homogène ou constitué d'une superposition de couches composées de différents éléments. La figure 2a représente le résultat obtenu après un apport d'un revêtement 20 sur la surface intérieure 1 du substrat. Cette étape permet de déposer une épaisseur e' de revêtement de manière très précise. L'épaisseur e' de revêtement peut être comprise entre 1 nm et 10 µm, notamment entre 1 nm et 1 µm. Cette épaisseur e' permet de définir la future couleur ainsi que la transparence résultante de la pièce transparente colorée, notamment de la glace de montre. Un compromis sera donc effectué. Une épaisseur trop faible de revêtement ne permet pas de colorer, ce qui définit la borne inférieure de l'épaisseur e'. Une épaisseur trop importante ne permet pas de conserver une transparence suffisante du substrat, ce qui définit la borne supérieure de l'épaisseur e'. Cette plage d'épaisseur dépend de l'élément chimique colorant, du matériau transparent du substrat, et du traitement thermique qui sera appliqué, détaillé ci-après.

D'autre part, le revêtement peut être uniforme, c'est-à-dire d'épaisseur constante sur toute la surface du substrat, pour atteindre un résultat homogène. En variante, il peut être souhaité d'obtenir un résultat hétérogène ; dans ce cas, le revêtement peut être non uniforme.

Par exemple, le revêtement peut être discontinu. Pour cela, le procédé comprend une étape préalable consistant à déposer un masque, par exemple une résine, sur la ou les surfaces concernées par l'apport du revêtement, pour n'obtenir un revêtement que partiel, en dehors des zones masquées. Ensuite, après application du revêtement, le masque est supprimé. Le masquage peut être plus ou moins dense, pour former un dégradé de couleur en fonction de la densité de masquage.
Une alternative pourrait consister à revêtir la surface du substrat sans tenir compte des motifs et de venir ôter la couche de manière sélective pour venir dessiner les motifs.
Par exemple, il est possible d'obtenir le dépôt d'un revêtement d'épaisseur variable, par une méthode sous vide directionnelle, comme le dépôt PVD MS. Un gradient d'épaisseur d'un revêtement 20 peut être obtenu par inclinaison du substrat durant le dépôt ou par un masquage adapté ou toute autre approche adaptée.

En alternative, l'apport de l'au moins un élément chimique colorant peut se faire par implantation ionique directe, sans l'intermédiaire d'un revêtement. L'inconvénient de cette dernière alternative réside dans la difficulté de contrôler la quantité d'éléments chimiques colorants qui pourra être introduite dans le substrat, et dans la difficulté d'obtenir une définition précise d'un motif par masquage.

Préférentiellement, l'apport de l'au moins un élément chimique colorant se fait sur une seule surface intérieure ou extérieure du substrat. En variante, cet apport peut être effectué sur les deux surfaces intérieure et extérieure, voire même sur tout ou partie du flanc 3.

L'élément chimique colorant peut être choisi dans la liste non exhaustive suivante :
- Un élément métallique, choisi notamment parmi les métaux de transition ; ou
- Un oxyde, notamment métallique, formé notamment à base de métaux de transition ; ou
- Un alliage métallique ; ou
- un métalloïde, un non-métal ou un gaz.

L'élément chimique colorant est associé au matériau du substrat pour obtenir une couleur souhaitée. En particulier, pour la coloration en bleu d'un substrat en alumine, il est connu d'utiliser le cobalt. Bien sûr, les éléments colorants tels que le fer, le titane, l'or, le chrome, le vanadium, le cuivre, le manganèse, le magnésium, le zinc, l'argent, le bore, l'azote, etc..., peuvent être utilisés pour obtenir d'autres couleurs, seuls ou combinés. Ainsi, il est possible de réunir plusieurs éléments distincts, par exemple plusieurs éléments chimiques colorants parmi la liste précédente. Par exemple, un ajout de chrome ou d'or dans l'alumine peut donner une couleur rouge, et des ajouts de titane et de fer combinés peuvent donner du bleu.

En remarque, avant l'étape d'apport de ou des éléments chimiques colorants, le procédé comprend avantageusement une étape de nettoyage du substrat. Le nettoyage peut consister en un lavage lessiviel suivi de rinçage(s) et de séchage(s).

Ensuite, le procédé comprend la mise en oeuvre d'une deuxième étape principale de traitement thermique E2 dudit substrat issu de l'étape d'apport E1, comprenant au moins un élément chimique colorant. Ce traitement thermique comprend la mise en oeuvre d'une étape de chauffage du substrat issu de l'étape précédente, puis une étape de maintien du substrat à une température de palier durant une durée de palier, avant une étape de refroidissement du substrat.

La température maximale de palier est surtout importante pour remplir la fonction de transfert du ou des éléments chimiques colorants au sein du substrat initial. La durée du palier permet d'impacter la quantité d'éléments chimiques colorants diffusés et/ou ayant réagi, et donc de moduler la couleur finale, plus ou moins intense. Cette durée peut donc être choisie selon une plage très large. Enfin, les vitesses de changements de température sont secondaires dans la fonction de coloration, et seront choisies pour éviter toute agression du substrat initial, notamment pour éviter tout choc thermique.

Avantageusement, la température de palier est comprise entre 500°C et 1850°C, voire entre 800°C et 1400°C ; plus particulièrement, la température de palier est comprise entre 900°C et 1200°C pour le cas d'un substrat initial en alumine monocristalline comportant un revêtement de cobalt à l'issue de l'étape d'apport E1. La durée du palier associée peut être très longue (jusqu'à plusieurs jours) ; elle est avantageusement comprise entre 0.5 et 48 heures pour le cas particulier d'un substrat initial en alumine monocristalline comportant un revêtement de cobalt à l'issue de l'étape E1, voire plus généralement entre 0.5 heure et quatre jours.

Le traitement thermique peut être fait à l'air ambiant. Selon une variante, il est réalisé dans une atmosphère contrôlée, inerte, oxydante ou réductrice, voire sous vide. Notamment, le traitement thermique peut être réalisé sous atmosphère d'azote. Selon d'autres variantes encore, les flux et les pressions de gaz peuvent être variés. De plus, cette deuxième étape de traitement thermique E2 peut être mise en oeuvre au sein d'un deuxième équipement distinct d'un premier équipement prévu pour la mise en oeuvre de la première étape d'apport E1. Alternativement, cette deuxième étape E2 peut être mise en oeuvre au sein du même équipement que celui utilisé pour la première étape d'apport E1.

La figure 2b illustre schématiquement le résultat obtenu après traitement thermique du substrat issu de la première étape, représenté par la figure 2a. On obtient à l'issue du traitement thermique une zone de composition chimique modifiée 30 d'épaisseur d au sein du volume du substrat, à proximité de la surface intérieure 1. Cette zone de composition modifiée remplit la fonction de coloration. Par exemple, l'alumine cristallisée de composition Al₂O₃, initialement incolore et transparente, peut devenir bleue avec un ajout dosé de cobalt, en formant une zone de composition modifiée en CoAl₂O₄ et/ou peut devenir verte avec un ajout dosé de cobalt en formant une zone de composition modifiée par substitution du cobalt dans l'alumine. Selon un autre exemple, un ajout de magnésium à l'alumine Al₂O₃, permet d'obtenir l'aluminate de magnésium MgAl₂O₄. Selon encore un autre exemple, un ajout d'or à l'alumine Al₂O₃ permet d'obtenir une coloration par effet plasmonique. Une coloration par la formation de composés intermétalliques peut également être envisagée. Cette étape finit de transformer le substrat initial en une pièce transparente et colorée. La zone de composition chimique modifiée 30 est ainsi colorée et produit de manière surprenante le même effet visuel qu'une glace qui aurait été colorée dans la masse, donc dans tout son volume, sur toute son épaisseur. Pourtant, la zone de composition chimique modifiée ne s'étend que sur une très faible épaisseur d, comprise entre 30 et 500 nm, représentant en moyenne au maximum 25% inclus, voire au maximum 2% inclus, voire au maximum 0.2% inclus, et préférentiellement au maximum 0.07% inclus de l'épaisseur totale e du composant horloger dans le cas d'une coloration effectuée sur une seule surface, intérieure ou extérieure. La pièce transparente et colorée ainsi formée se compose ainsi toujours principalement du matériau transparent provenant du substrat 10 initial, et d'un petit volume de matériau transparent chimiquement modifié et coloré.

Par le procédé ainsi mis en oeuvre, une pièce transparente et colorée est obtenue, qui ne nécessite pas de reprise de son état de surface, même pas de la surface traitée. En effet, l'épaisseur e' de revêtement en élément(s) chimique(s) colorant(s) peut être prévue de manière à ce que le ou les éléments chimiques colorants diffusent intégralement dans le substrat 10 et/ou réagissent entièrement avec le substrat 10 au cours du traitement thermique. Potentiellement, il n'est donc pas nécessaire d'éliminer un excédent d'élément chimique colorant car le procédé peut être prévu de manière à ce que l'intégralité de la quantité d'élément chimique colorant soit consommée par le procédé au cours du traitement thermique. Alternativement, on peut procéder à l'élimination d'un éventuel résidu d'élément chimique colorant en surface de la pièce si nécessaire, par tout moyen connu de l'homme de métier (décapage, dissolution, attaque chimique, polissage, ...).

A la fin de cette deuxième étape, le procédé peut comprendre des étapes de finalisation du composant horloger, notamment de la glace de montre. Par exemple, si le substrat initial n'est pas une glace de montre terminée, par exemple s'il n'avait pas la forme souhaitée, la glace de montre peut être obtenue par usinage de la pièce transparente et colorée obtenue, notamment par usinage des flancs de la glace. A titre d'exemple, une large plaque en saphir peut être produite et colorée, puis usinée par exemple avec un laser pour obtenir de plus petits composants horlogers tels que des palettes, des roues, des glaces, etc. De préférence, une étape de finalisation ne modifie pas la zone de composition chimique modifiée au sein dudit composant.

Alternativement, une étape d'usinage complémentaire peut être réalisée pour finaliser le composant horloger, en particulier la glace de montre, par exemple simplement pour former un biseau ou toute partie 4 périphérique, notamment une partie inclinée, telle qu'illustrée par les figures 1b à 1e, et/ou pour former une gorge ou un cyclope ou une loupe.
En variante, cette étape peut consister en la structuration d'un motif dans la pièce transparente colorée, par exemple avec un laser, dans un but purement décoratif ou de marquage. Ainsi de manière avantageuse, un gravage laser au sein de la glace de montre ne nécessite aucune adaptation de paramètres, puisqu'il agit sur la zone incolore de la glace, c'est-à-dire en dehors de la zone de composition chimique modifiée, quelle que soit la couleur de la glace obtenue selon l'invention.

En variante, cette étape peut consister à former une structuration de la pièce colorée. Une « structuration » peut former des zones en relief et/ou en retrait sur au moins une surface extérieure ou intérieure de la pièce colorée, de manière à créer un relief perceptible ou alors à modifier l'épaisseur colorée de manière à créer un ou des motifs en couleur ou en dégradé de couleur ou de la couleur du substrat initial. Une structuration peut être toute ouverture non traversante formée en surface ou dans l'épaisseur de la pièce colorée. Une telle ouverture peut être une micro-ouverture ou une nano-ouverture, de préférence de taille suffisamment petite pour être invisible ou sensiblement invisible à l'oeil nu. Alternativement, une telle ouverture peut présenter une dimension plus importante, macroscopique, pour la rendre volontairement visible. Dans tous les cas, les ouvertures peuvent présenter toute section, non nécessairement circulaire. Cette section peut en effet être rectangulaire ou en étoile, par exemple, ou présenter toute autre géométrie appropriée. Une telle structuration peut être notamment obtenue par toute technique d'usinage conventionnelle, ou par usinage laser, notamment par usinage laser femto-seconde, ou par gravure ionique réactive profonde (Deep Reactive Ion Etching, DRIE) ou encore par attaque chimique. En remarque, une étape de structuration pourrait être réalisée en phase initiale du procédé, directement sur le substrat initial mis à disposition, avant la mise en oeuvre des deux étapes principales du procédé selon l'invention. En variante, une étape de structuration peut être réalisée après la première étape d'apport E1 du procédé, directement sur le revêtement déposé sur le substrat, et avant la mise en oeuvre de la deuxième étape de traitement thermique E2 du procédé selon l'invention.

Une étape supplémentaire peut aussi consister en l'assemblage de la pièce transparente et colorée obtenue avec un autre composant, obtenu par le même procédé ou non. Par exemple, cette étape supplémentaire peut consister à assembler une glace avec un cyclope ou une loupe ou à assembler, notamment à coller, une glace avec un support doté d'une jupe d'assemblage de ladite glace sur une boîte de montre, ou à assembler plusieurs glaces entre elles.

Finalement, le procédé de fabrication selon l'invention présente les avantages suivants :
- L'apport d'élément(s) chimique(s) colorant(s) est parfaitement maîtrisé, en quantité et localisation, ce qui permet de le calibrer et de le répéter pour obtenir un résultat souhaité et identique à chaque exécution ;
- De même, le traitement thermique est maîtrisé et répétable, pour obtenir de même une pièce transparente colorée souhaitée et identique à chaque exécution ;
- Le procédé est donc compatible avec une industrialisation en grande série et avec les exigences horlogères.

Le procédé s'applique de même à la fabrication de tout composant horloger transparent et permet de fabriquer un composant horloger transparent, qui comprend une surface intérieure sensiblement plane ou courbée, et qui comprend principalement un matériau transparent, coloré par une zone de composition chimique modifiée au sein dudit composant par un apport d'au moins un élément chimique colorant, cette zone de composition chimique modifiée s'étendant dans une partie seulement de l'épaisseur totale du composant horloger, c'est-à-dire pas sur toute son épaisseur, cette partie représentant en moyenne au maximum 25% inclus, voire au maximum 2% inclus, voire au maximum 0.2% inclus, et préférentiellement au maximum 0.07% inclus de l'épaisseur totale du composant horloger, l'épaisseur totale du composant horloger étant mesurée perpendiculairement à la surface intérieure dudit composant ou perpendiculairement à la tangente formée au sommet de la surface intérieure dudit composant. Avantageusement, la zone de composition chimique modifiée s'étend en moyenne sur une épaisseur représentant au minimum 0.0002% de l'épaisseur totale du composant horloger. En remarque, cette épaisseur du composant horloger sera avantageusement sensiblement celle du substrat initial. En variante de réalisation, cette épaisseur du composant horloger peut être réduite par rapport à l'épaisseur totale initiale du substrat initial, mais de sorte à conserver les plages mentionnées ci-dessus de l'épaisseur de la zone de composition chimique modifiée.

Ainsi, l'invention s'applique, par exemple, à la fabrication d'une glace de montre, d'un cyclope, d'une loupe, d'une partie d'un fond de boîte, d'un cadran, d'un disque de quantième, d'une pierre de mouvement horloger, de palettes, de roues.

Grâce au procédé selon l'invention, le composant horloger obtenu présente les avantages suivants :
- La coloration est prédictible (en teinte, particulièrement le bleu, et en saturation), répétable, répartie de façon souhaitée : elle est soit homogène sur l'ensemble de la surface visée, qui peut être très grande, par exemple dans le cas d'une glace saphir, soit hétérogène et contrôlée, par exemple en suivant un dégradé contrôlé, ou des motifs ou inscriptions prédéfinis. Elle donne une impression de coloration dans la masse, malgré la finesse de la zone de composition chimique modifiée colorée. Elle donne aussi une impression visuelle indépendante de la surface intérieure ou extérieure qui est traitée, et indépendante de l'épaisseur totale du composant horloger ;
- La transparence est garantie, pour permettre, dans le cas d'une glace de montre, la lecture de l'heure ou des indications dérivées de l'heure, la vue sur le cadran, la vue sur le réhaut de la carrure, etc. En complément, cette transparence permet aussi une éventuelle charge (excitation) et décharge (émission) de matière luminescente, en particulier photoluminescente (phosphorescente et/ou fluorescente) qui serait présente sous la glace (sur/dans des appliques, des aiguilles, des décalques, ...) ;
- La résistance mécanique globale du substrat initial est maintenue à l'issue du procédé : aucune détérioration des propriétés mécaniques n'est induite par le procédé ;
- La dureté de la surface du substrat initial est maintenue à l'issue du procédé, sur la pièce transparente colorée ;
- L'aspect du composant horloger est exempt de défaut, tels que des zones ponctuelles non colorées, différemment colorées, « sur-colorées », des piqûres, des aspects laiteux localisés, des porosités débouchantes, des halos. Cette absence de défaut est obtenue sur l'ensemble de la surface de la pièce transparente colorée obtenue, qui peut être importante, et parfaitement observable par un utilisateur, éventuellement même rétroéclairée ;
- Les effets peuvent être modulés par une surface additionnelle inclinée, au niveau du flanc du composant horloger, qui peut, par exemple, prendre la forme d'un biseau ;
- D'autres considérations géométriques peuvent venir moduler ces effets, comme des zones structurées en relief et/ou en retrait sur au moins une surface du composant horloger et/ou des zones structurées au sein de l'épaisseur du composant horloger.

L'invention va maintenant être illustrée par la mise en oeuvre de quelques séries d'exemples de réalisation.

Dans une première série d'exemples de réalisation, le substrat 10 en alumine monocristalline transparente incolore présente une géométrie correspondant à une géométrie finale d'une glace de montre terminée adaptée pour un montage sur une pièce d'horlogerie. Cette réalisation transparente correspond à la réalisation dite de « référence » dans le tableau ci-après et dans les différents exemples qui vont suivre.

Selon cet exemple, la glace de montre de référence mesure 29.5 mm de diamètre et présente une épaisseur totale de 1.8 mm. Elle présente une géométrie proche de celle représentée sur la figure 1e, avec un chanfrein sur le pourtour de sa surface extérieure incliné de 36°, sur une hauteur f de 0.8 mm ainsi qu'une gorge et divers usinages sur le reste de la hauteur du flanc 3. Ses surfaces extérieure et intérieure sont polies.

Le substrat initial, correspondant à la glace de montre de référence précisée ci-dessus, est lavé dans un bain lessiviel puis rincé et séché, puis disposé dans une enceinte d'un équipement PVD d'évaporation thermique. Un revêtement de cobalt métallique est ainsi déposé sur la surface intérieure du substrat initial, ce qui correspond à la première étape principale du procédé décrit précédemment. La vitesse et la durée de déposition sont calibrées afin que le revêtement mesure une épaisseur déterminée. L'épaisseur de dépôt est confirmée par réflectométrie de rayons X. Cette opération est répétée pour former une série de pièces colorées comprenant plusieurs épaisseurs différentes de revêtement e' (valeur de consigne), qui varient de 5 à 80 nm, comme résumé dans le tableau ci-après. Le traitement thermique selon la deuxième étape principale du procédé est mis en oeuvre de manière identique pour toutes les pièces de la série, avec un palier à une température de 1060°C durant 2 heures.

Des mesures spectrophotocolorimétriques, pratiquées en transmission sur les pièces colorées issues du procédé selon le mode de réalisation, formant plusieurs échantillons 1.1 à 1.9 à l'issue de l'étape de traitement thermique, sont effectuées. Les résultats dans l'espace CIELab sont présentés dans le tableau ci-après. Les mesures de transmittance sont réalisées entre 360 nm et 740 nm avec l'observateur à 2° et l'illuminant D65. La luminosité L*, les valeurs chromatiques a* et b*, la saturation C* et la teinte h* (ou angle de teinte) sont mesurées. Les valeurs de transmittance (T en %) sont relevées à 360 nm et à 460 nm. Le Y est un facteur de transmission ; il tient compte de la sensibilité de l'oeil et du type d'éclairage : il est calculé par l'intégration du spectre de transmittance pondéré par la fonction réponse de l'oeil humain (qui est centrée sur la partie verte du spectre visible) et par le spectre de l'illuminant D65 comme défini dans le « Technical Report of Colorimetry » CIE 15 : 2004. Ces résultats montrent notamment que la différence d'épaisseur de revêtement e' impacte directement la saturation et la teinte de la couleur bleue obtenue, de façon perceptible à l'oeil nu. A l'issue de l'étape d'apport E1, la glace obtenue a un aspect de plus en plus gris métallique et est de moins en moins transparente, à mesure que cette épaisseur e' augmente. A l'issue de l'étape de traitement thermique E2, la glace a un aspect bleu de plus en plus saturé tout en restant transparente dans une gamme d'épaisseur e' de cobalt entre 5 nm et 45 nm. Au-delà de cette épaisseur, pour le traitement thermique donné, la transparence et donc la transmittance chutent.

Par exemple, pour l'échantillon 1.9 (e' = 80 nm), la transmittance vaut :
- 55.0% à 460 nm, si bien que la lisibilité au travers de cette glace n'est plus suffisante et,
- 38.0% à 360 nm, si bien que la charge d'une matière photoluminescente (phosphorescente et/ou fluorescente) au travers de cette glace n'est plus suffisante.
Dans le cas spécifique de cette série d'exemples, on constate que les échantillons avec une épaisseur e' inférieure ou égale à 12 nm permettent une lisibilité excellente. Ceux qui présentent une épaisseur e' inférieure ou égale à 45 nm permettent une lisibilité acceptable. Pour une épaisseur e' de 80 nm, l'échantillon permet une lecture troublée, car la glace est translucide. Pour une épaisseur e' de 80 nm, la lecture devient plus difficile, car la glace devient moins transparente.

Le tableau ci-dessous donne les résultats obtenus pour les échantillons de cette série selon le premier exemple :

| **Echantillon** | **e' [nm]** | **L*** | **a*** | **b*** | **C*** | **h*** | **T [%] à 360 nm** | **T [%] à 460 nm** | **Y [%]** | **Couleur perçue** |
|---|---|---|---|---|---|---|---|---|---|---|
| **Référence** | 0 | 93.5 | 0.0 | 0.4 | 0.4 | 87.0 | 82.1 | 83.6 | 86.0 | Incolore |
| **1.1** | 5 | 92.8 | -1.1 | -1.3 | 1.7 | 227.8 | 82.6 | 84.3 | 81.3 | Bleu |
| **1.2** | 6 | 92.7 | -1.1 | -1.7 | 2.0 | 235.5 | 82.7 | 84.4 | 82.3 | Bleu |
| **1.3** | 8 | 92.4 | -1.5 | -2.1 | 2.6 | 234.7 | 82.6 | 84.4 | 81.4 | Bleu |
| **1.4** | 9 | 92.1 | -1.7 | -2.4 | 3.0 | 234.8 | 82.6 | 84.1 | 80.8 | Bleu |
| **1.5** | 10 | 91.9 | -1.8 | -2.7 | 3.3 | 235.5 | 82.6 | 84.0 | 80.4 | Bleu |
| **1.6** | 12 | 91.5 | -2.0 | -3.2 | 3.8 | 237.9 | 82.9 | 84.0 | 79.7 | Bleu |
| **1.7** | 30 | 88.6 | -3.3 | -8.0 | 8.6 | 247.2 | 81.0 | 83.6 | 73.3 | Bleu |
| **1.8** | 45 | 86.2 | -5.0 | -11.8 | 12.8 | 247.0 | 78.6 | 83.5 | 68.4 | Bleu |
| **1.9** | 80 | 71.7 | -7.7 | -8.0 | 11.1 | 225.5 | 38.0 | 55.0 | 43.2 | Bleu-gris |

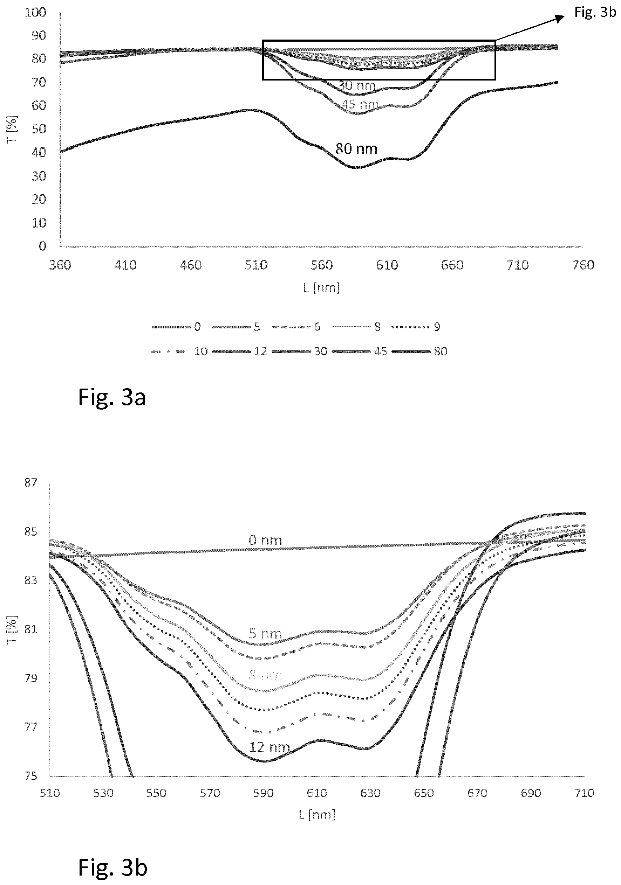

Pour illustrer ces résultats, la figure 3a représente les spectres de transmittance (T en %) en fonction de la longueur d'onde (L en nm) pour plusieurs épaisseurs de revêtement selon la série de ce premier exemple. La figure 3b est un agrandissement de cette figure 3a.

En complément, on note que quand on observe la glace, la coloration paraît plus intense au travers du biseau périphérique qu'au travers de sa surface extérieure plane. Autrement dit, l'effet coloré est modulé par l'angle α. Cet effet trouve son origine dans la géométrie de la pièce. Cela permet d'illustrer l'intérêt de proposer une partie inclinée au niveau de la surface extérieure de la glace, comme cela a été mentionné précédemment et est illustré sur les figures 1b à 1e.

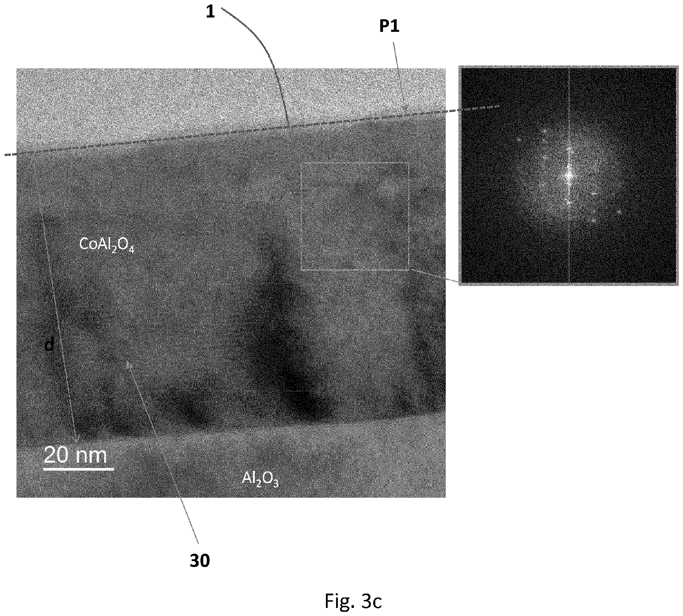

En remarque, la teinte bleue constatée provient d'une réaction chimique du cobalt, de l'alumine et de l'oxygène, donnant un aluminate de cobalt, potentiellement CoAl₂O₄, lors du traitement thermique, au niveau de la zone de composition chimique modifiée de la pièce transparente colorée obtenue. La figure 3c est une image prise au Microscope Électronique à Transmission (MET) sur une lame mince prélevée par faisceau d'ions focalisé (FIB) sur la pièce transparente colorée, perpendiculairement à la surface intérieure de la pièce transparente colorée obtenue. Un encart de cette figure présente un cliché de diffraction électronique acquis dans la zone proche de la surface intérieure traitée, et plus précisément à une distance inférieure à d de cette surface. Cette image permet de confirmer la formation d'aluminate de cobalt lors de la phase de coloration de la glace saphir ainsi que l'épaisseur d.

Les propriétés mécaniques globales des glaces obtenues ne sont pas dégradées par la mise en oeuvre du procédé selon l'invention. Ce résultat est vérifié sur un lot d'échantillons supplémentaires de glaces de montre, toujours obtenus à partir du même substrat de référence, revêtu par pulvérisation cathodique magnétron avec des couches de différentes épaisseurs de cobalt, puis traités thermiquement avec un palier de trois heures à 1000°C. La résistance à la rupture et la dureté des glaces ne sont aucunement affectées par la présence de la zone de composition chimique modifiée colorée.

Dans une deuxième série d'exemples de réalisation, le substrat initial 10 en alumine monocristalline transparente incolore utilisé présente une géométrie correspondant à une géométrie finale d'une glace de montre terminée, dite de référence, de manière identique à la série selon le premier exemple décrit ci-dessus. Des échantillons de pièces colorées sont formés en faisant varier le traitement thermique appliqué, plus précisément en variant la température du palier de trois heures. Tous ces échantillons ont préalablement été revêtus par évaporation thermique d'un dépôt de 10 nm de cobalt métallique sur la surface intérieure du substrat.

Le tableau ci-après résume les résultats obtenus pour ces échantillons :

| **Echantillon** | **Tp [°C]** | **L*** | **a*** | **b*** | **C*** | **h*** | **T [%] à 360 nm** | **T [%] à 460 nm** | **Y [%]** | **Couleur perçue** |
|---|---|---|---|---|---|---|---|---|---|---|
| **Référence** | / | 93.5 | 0 | 0.4 | 0.4 | 87.0 | 82.1 | 83.6 | 86.0 | Incolore |
| **2.1** | 900 | 89 | -2.6 | 3.6 | 4.8 | 137.7 | 65.8 | 70.2 | 74.2 | Vert |
| **2.2** | 1000 | 91.8 | -1.8 | -2.7 | 3.2 | 236.3 | 81.5 | 83.9 | 80.3 | Bleu |
| **2.3** | 1200 | 92 | -1.7 | -2.6 | 3.1 | 236 | 82.9 | 84.1 | 80.7 | Bleu |
| **2.4** | 1400 | 94.1 | 0 | 0.1 | 0.2 | 80 | 84.7 | 85.2 | 85.4 | Incolore |

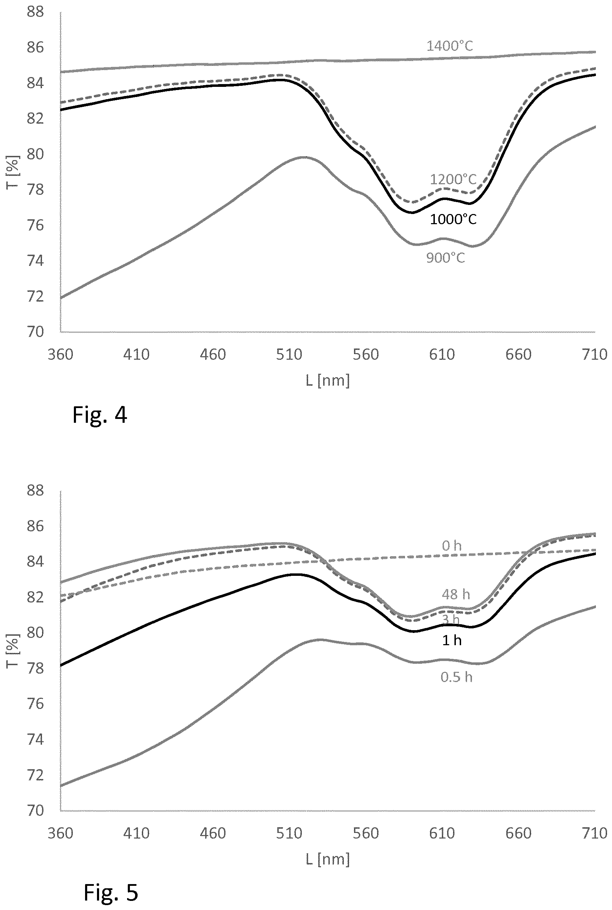

En complément, la figure 4 représente les spectres de transmittance (T en %) en fonction de la longueur d'onde (L en nm) pour plusieurs températures (Tp en °C) de palier selon la série de ce deuxième exemple.

On constate notamment que les échantillons 2.1 à 2.3 ont un angle de teinte qui augmente avec la température de palier, que l'échantillon 2.1 est vert alors que les échantillons 2.2 et 2.3 sont bleus. Au-delà d'un traitement à 1400°C (échantillon 2.4), la glace saphir devient transparente et incolore, similaire à une glace saphir non traitée (échantillon de référence).

Une troisième série d'exemples de réalisation permet d'obtenir des échantillons de manière similaire à la deuxième série, mais en faisant varier la durée du palier de traitement thermique appliqué de 30 minutes à 48 heures, pour une température de palier toujours égale à 900°C. Tous ces échantillons ont préalablement été revêtus par évaporation thermique d'un dépôt de 5 nm de cobalt métallique sur la surface intérieure du substrat.

Le tableau ci-après résume les résultats obtenus pour ces échantillons :

| **Echantillon** | **t[h]** | **L*** | **a*** | **b*** | **C*** | **h*** | **T [%] à 360 nm** | **T [%] à 460 nm** | **Y[%]** | **Couleur perçue** |
|---|---|---|---|---|---|---|---|---|---|---|
| **Référence** | 0 | 93.5 | 0.0 | 0.4 | 0.4 | 87.0 | 82.1 | 83.6 | 86.0 | Incolore |
| **3.1** | 0.5 | 90.2 | -1.6 | 3.3 | 3.7 | 116.3 | 70.2 | 74.4 | 78.3 | Gris-vert |
| **3.2** | 1 | 92.3 | -1.4 | 0.4 | 1.5 | 165.6 | 77.1 | 81.1 | 81.4 | Vert |
| **3.3** | 3 | 92.9 | -1.0 | -1.3 | 1.6 | 230.3 | 81.9 | 84.5 | 82.7 | Bleu |
| **3.4** | 48 | 93 | -1.0 | -1.3 | 1.6 | 234.6 | 82.8 | 84.7 | 82.8 | Bleu |

En complément, la figure 5 représente les spectres de transmittance (T en %) en fonction de la longueur d'onde (L en nm) pour plusieurs durées (t en h) de palier selon la série de ce troisième exemple.

On constate notamment qu'avec l'augmentation de la durée du traitement thermique, le revêtement réagit plus efficacement avec la glace, ce qui se traduit par une augmentation de la transmittance et l'établissement de la couleur bleue. Après trois heures de palier de traitement thermique (échantillon 3.3), la glace saphir est bleue et suffisamment transparente dans les longueurs d'onde permettant à la fois la bonne lisibilité et l'éventuelle charge et décharge de matière photoluminescente.

Dans une quatrième série d'exemples de réalisation, le substrat initial 10 utilisé correspond toujours à la glace de montre terminée de référence, de manière identique à la série selon le premier exemple décrit ci-dessus. Des échantillons sont réalisés en faisant varier le traitement thermique appliqué, plus précisément la température et/ou la durée du palier appliquée(s). Tous ces échantillons ont préalablement été implantés de fer, cobalt ou titane, par un procédé d'implantation ionique par faisceau ionique (implantation directe des ions du faisceau ionique).

Le tableau ci-après résume les résultats obtenus par ces échantillons :

| **Echantillon** | **Implantation** | **Traitement thermique** | **L*** | **a*** | **b*** | **C*** | **h*** | **T (%) 360 nm** | **T (%) 460n m** | **Y [%]** | **Couleu r perçue** |
|---|---|---|---|---|---|---|---|---|---|---|---|
| **référence** | aucune | aucun | 94.2 | 0.1 | 0.2 | 0.2 | 69.7 | 85.3 | 85.6 | 85.8 | Incolore |
| **4.1** | Fer | aucun | 75.2 | 0.4 | 7.5 | 7.5 | 86.9 | 32.0 | 42.4 | 48.5 | Brun |
| **4.2** | Fer | 900°C 30 min | 86.3 | 2.0 | 16.7 | 16.8 | 83.3 | 36.5 | 52.7 | 68.5 | Orange |
| **4.3** | Fer | 1000°C 3h | 87.0 | 1.9 | 16.7 | 16.8 | 83.5 | 42.1 | 53.7 | 70.0 | Orange |
| **4.4** | Fer | 1600°C 3h | 94.1 | 0.0 | 0.1 | 0.1 | 80.0 | 85.0 | 85.2 | 85.4 | Incolore |
| **4.5** | Cobalt | 900°C 30 min | 86.5 | -2.7 | 5.5 | 6.1 | 116.0 | 57.5 | 62.9 | 69.0 | Gris-vert |
| **4.6** | Cobalt | 1000°C 3h | 92.0 | -1.8 | -2.9 | 3.4 | 238.5 | 83.0 | 84.7 | 80.8 | Bleu |
| **4.7** | Cobalt | 1600°C 3h | 94.2 | 0.0 | 0.2 | 0.2 | 84.6 | 85.3 | 85.5 | 85.7 | Incolore |
| **4.8** | Titane | 900°C 30 min | 91.8 | -3.6 | 5.7 | 6.7 | 121.9 | 41.2 | 74.1 | 80.3 | Jaune |
| **4.9** | Titane | 1000°C 3h | 91.8 | -5.0 | 10.1 | 11.3 | 116.5 | 37.4 | 69.1 | 80.2 | Jaune |

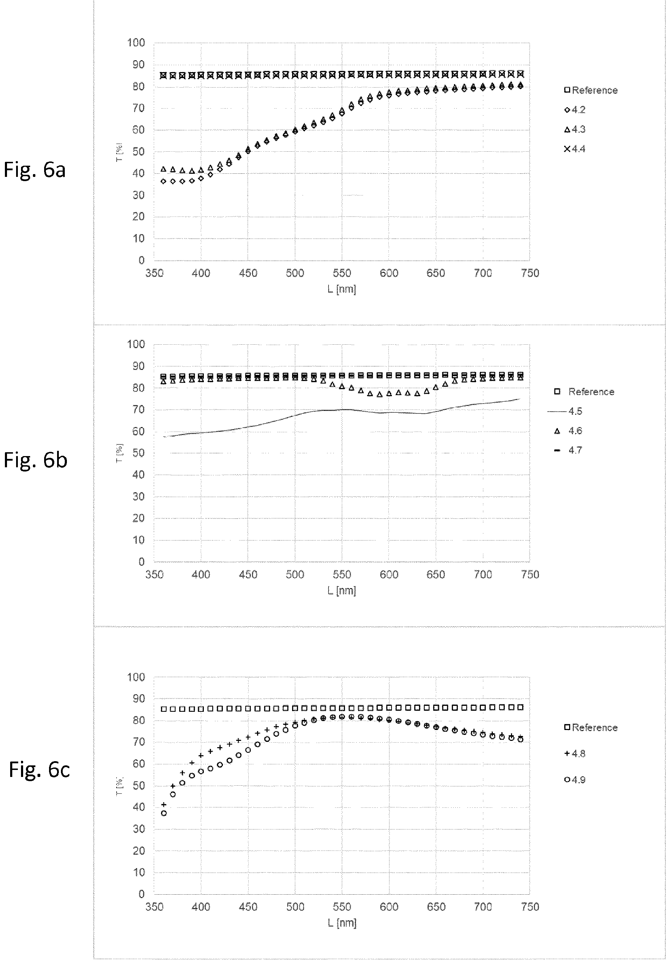

En complément, les figures 6a à 6c représentent les spectres de transmittance (T en %) en fonction de la longueur d'onde (L en nm) pour les échantillons formant la série de ce quatrième exemple.

On constate notamment que le fer donne une couleur orangée (à 900°C et 1000°C), que le cobalt donne une couleur grise à 900°C et bleue à 1000°C, le titane donne un léger jaunissement (à 900°C et 1000°C). Que ce soit avec le fer ou le cobalt, le traitement à 1600°C donne une glace transparente et incolore.

Les valeurs de dureté et de module élastique obtenues par nano-indentation sur les échantillons formant la série de ce quatrième exemple permettent de conclure que les propriétés mécaniques (dureté et élasticité) de la glace saphir ne sont pas influencées par le procédé de coloration impliquant l'implantation ionique et les traitements thermiques, dans les conditions testées.

Dans une cinquième série d'exemples de réalisation, le substrat initial 10 en alumine monocristalline transparente incolore utilisé présente une géométrie correspondant à une géométrie finale d'une glace de montre terminée, dite de référence, de manière identique à la série selon le premier exemple décrit ci-dessus.
Le substrat initial, correspondant à la glace de montre de référence, est lavé dans un bain lessiviel puis rincé et séché, puis disposé dans une enceinte d'un équipement PVD d'évaporation thermique. Un revêtement de cobalt métallique est ainsi déposé sur la surface intérieure 1 ou extérieure et biseau 2+4, du substrat initial. Cette opération est répétée pour former une série de pièces colorées comprenant plusieurs épaisseurs différentes de revêtement e' (valeur de consigne), de 3, 6 ou 9 nm, comme résumé dans le tableau ci-après. L'implantation par recul est mise en oeuvre de manière similaire pour toutes les pièces de la série, dans un même équipement, par la méthode de l'immersion plasma, avec un bombardement par des ions d'argon ; seule la dose d'ions implantés (D exprimée en atomes/cm² avec une énergie de 10 kV) change, comme résumé dans le tableau ci-après. Ces opérations correspondent à la première étape principale du procédé décrit précédemment.
Le traitement thermique selon la deuxième étape principale du procédé est mis en oeuvre de manière identique pour toutes les pièces de la série, avec un palier à une température de 1000°C durant 3 heures.

Le tableau ci-après résume les résultats obtenus pour ces échantillons :

| **Echantillon** | **e' [nm]** | **D Dose [at/cm²]** | **Surface** | **L*** | **a*** | **b*** | **C*** | **h*** | **T [%] à 360 nm** | **T [%] à 460 nm** | **Y [%]** | **Couleu r perçue** |
|---|---|---|---|---|---|---|---|---|---|---|---|---|
| **Référence** | 0 | / | / | 93.5 | 0.0 | 0.4 | 0.4 | 87.0 | 82.1 | 83.6 | 86.0 | Incolore |
| **5.1** | 3 | 3.0 10¹⁵ | 1 | 93.4 | -0.6 | -0.9 | 1.0 | 236.4 | 83.4 | 85.2 | 83.9 | Bleu |
| **5.2** | 6 | 1.0 10¹⁶ | 1 | 93.2 | -0.8 | -1.6 | 1.8 | 242.4 | 84.0 | 85.6 | 83.4 | Bleu |
| **5.3** | 9 | 1.0 10¹⁶ | 1 | 92.0 | -1.8 | -2.3 | 2.9 | 233.0 | 81.6 | 83.9 | 80.8 | Bleu |
| **5.4** | 3 | 3.0 10¹⁵ | 2+4 | 93.4 | -0.6 | -0.8 | 1.0 | 236.3 | 83.4 | 85.2 | 84.0 | Bleu |
| **5.5** | 6 | 1.0 10¹⁶ | 2+4 | 93.2 | -0.7 | -1.5 | 1.6 | 245.4 | 84.3 | 85.4 | 83.4 | Bleu |
| **5.6** | 9 | 1.0 10¹⁶ | 2+4 | 92.2 | -1.7 | -2.3 | 2.9 | 234.2 | 82.1 | 84.3 | 81.1 | Bleu |

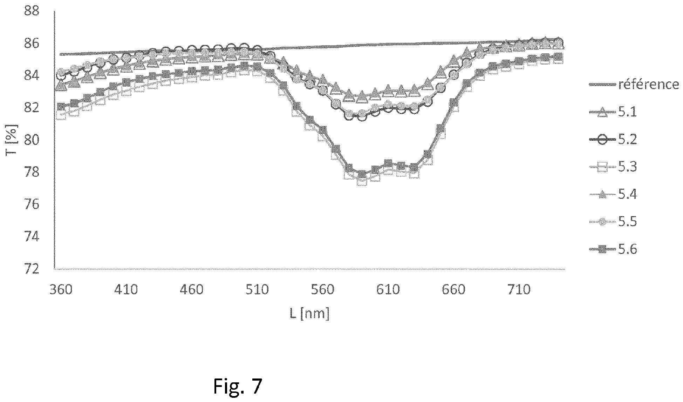

En complément, la figure 7 représente les spectres de transmittance (T en %) en fonction de la longueur d'onde (L en nm) pour plusieurs valeurs d'épaisseurs de revêtement e' et doses d'ions implantés D selon la série de ce cinquième exemple.

On constate notamment que les échantillons obtenus sont bleus ; les échantillons 5.1 à 5.3 et 5.4 à 5.6 ont une saturation C* qui augmente avec l'épaisseur de revêtement e'. A paramètres de traitement identiques, les résultats sont similaires quelle que soit la surface traitée (surface 1 ou surfaces 2+4).

Le sixième exemple s'intéresse particulièrement à l'impact d'une glace de montre colorée, bleue dans cet exemple, sur les performances de charge (excitation) et décharge (émission) d'une matière photoluminescente qui serait disposée sur un cadran sous la surface intérieure de la glace de montre. Une glace bleue (échantillon 6) est préparée selon le mode de réalisation dans lequel un dépôt de 9 nm de cobalt est effectué par évaporation thermique sur un substrat 10 en alumine monocristalline transparente incolore, et suivi d'un traitement thermique comprenant un palier de 2 heures à 1060°C.

Les résultats de mesures spectrophotocolorimétriques en transmission réalisées sur l'échantillon 6 et sur la glace de référence sont donnés dans le tableau ci-dessous.

| **Echantillon** | **e' [nm]** | **L*** | **a*** | **b*** | **C*** | **h*** | **T (%) 360 nm** | **T (%) 460 nm** | **Y [%]** | **T [°C]** | **d [h]** | **Couleur perçue** |
|---|---|---|---|---|---|---|---|---|---|---|---|---|
| **Référence** | 0 | 93.5 | 0.0 | 0.4 | 0.4 | 87.0 | 85.3 | 85.6 | 86.0 | - | - | Incolore |
| **6** | 9 | 92.1 | -1.7 | -2.4 | 2.9 | 235.1 | 82.7 | 84.3 | 80.9 | 1060 | 2 | Bleu |

Les deux glaces (de référence et de l'échantillon 6) sont montées successivement sur la même montre, comportant des appliques et des aiguilles avec une matière photoluminescente commerciale. Les performances lumineuses de l'assemblage avec la glace bleue (échantillon 6) et avec la glace de référence sont comparées après maintien de la montre dans l'obscurité plus de 24 heures, suivi d'une illumination normée (20 minutes à 400 lux avec illuminant D65). La décroissance lumineuse [nCd] en fonction du temps de maintien dans l'obscurité est mesurée par photométrie. La baisse relative de performance lumineuse de la glace bleue (échantillon 6) est évaluée en pourcents de l'intensité lumineuse de la glace de référence.
La baisse relative de performance lumineuse due à la coloration de l'échantillon 6 est de 0.8% de 0 à 8 heures et de 1.7% de 0 à 22 heures.
En comparaison d'une glace incolore de référence, l'utilisation d'une glace bleue selon l'échantillon 6 n'a donc pas d'influence perceptible par le porteur de la montre sur les performances de la matière photoluminescente testée.

Naturellement, les exemples précédents sont réalisés de manière non limitative, pour illustrer les résultats obtenus avec la mise en oeuvre du concept de l'invention. Ils pourraient être reproduits sur tout autre composant horloger transparent qu'une glace de montre, avec des effets similaires.

Les résultats illustrent bien les avantages obtenus par le procédé de l'invention. Sur cette base, l'homme du métier saura adapter les épaisseurs de dépôt e', les matériaux à utiliser, et les paramètres du traitement thermique en fonction du résultat qu'il souhaite atteindre, notamment en termes de couleur et de transparence. Notamment, il sera avantageux de choisir d'atteindre un facteur de transmission (Y) supérieur ou égal à 68% inclus, voire supérieur ou égal à 79% inclus. Il pourra aussi être choisi un substrat tel que le composant horloger obtenu présente une dureté moyenne de la surface extérieure supérieure ou égale à 30 GPa et/ou supérieure ou égale à 2016 HV0.2, particulièrement dans le cas d'une glace de montre.

## Revendications

1. Composant horloger transparent, notamment glace de montre, **caractérisé en ce qu'**il comprend une surface intérieure sensiblement plane ou courbée, et **en ce qu'**il comprend principalement un matériau transparent, coloré par une zone de composition chimique modifiée au sein dudit composant par un apport d'au moins un élément chimique colorant audit matériau transparent, cette zone de composition chimique modifiée s'étendant dans une partie seulement de l'épaisseur totale du composant horloger.

2. Composant horloger selon la revendication précédente, **caractérisé en ce que** la zone de composition chimique modifiée s'étend sur une épaisseur représentant en moyenne au maximum 25% inclus, voire au maximum 2% inclus, voire au maximum 0.2% inclus, voire au maximum 0.07% inclus de l'épaisseur totale du composant horloger.

3. Composant horloger selon l'une des revendications précédentes, **caractérisé en ce que** la zone de composition chimique modifiée s'étend sur une épaisseur représentant en moyenne au minimum 0.0002% de l'épaisseur totale du composant horloger.

4. Composant horloger selon l'une des revendications précédentes, **caractérisé en ce que** ledit matériau transparent, incolore ou préalablement coloré, est un matériau inorganique et/ou minéral, comme de l'alumine synthétique monocristalline ou saphir, du corindon, ou **en ce que** ledit matériau transparent est un matériau composé au moins partiellement de matière inorganique et/ou minérale, comme du verre, du corindon, de l'alumine, un matériau à base de grenat d'yttrium et d'aluminium (YAG), de la vitrocéramique et/ou de la céramique mono ou polycristalline.

5. Composant horloger selon l'une des revendications précédentes, **caractérisé en ce qu'**au moins un élément chimique colorant est choisi parmi un métal, et/ou un oxyde métallique, et/ou un composé métallique, et/ou un alliage métallique, et/ou un métal de transition, et/ou un oxyde de métal de transition et/ou un métalloïde et/ou un non-métal et/ou un gaz.

6. Composant horloger selon la revendication précédente, **caractérisé en ce qu'**au moins un élément chimique colorant est choisi parmi le cobalt, et/ou le fer, et/ou le chrome, et/ou l'or, et/ou le titane, et/ou le vanadium, et/ou le cuivre, et/ou le manganèse, et/ou le magnésium, et/ou le zinc, et/ou l'argent, et/ou le bore, et/ou l'azote.

7. Composant horloger selon l'une des revendications précédentes, **caractérisé en ce que** la zone de composition chimique modifiée comprend de l'aluminate de cobalt et/ou du cobalt de sorte à obtenir un composant horloger de couleur bleue et/ou verte ou **en ce que** la zone de composition chimique modifiée comprend de l'or de sorte à obtenir un composant horloger de couleur rose ou rouge.

8. Composant horloger selon l'une des revendications précédentes, **caractérisé en ce qu'**il présente une surface intérieure présentant une superficie supérieure ou égale à 20 mm² et une épaisseur supérieure ou égale à 0.85 mm.

9. Composant horloger selon l'une des revendications précédentes, **caractérisé en ce qu'**il est une glace de montre présentant une surface intérieure présentant une superficie supérieure ou égale à 80 mm² voire supérieure ou égale à 200 mm², voire supérieure ou égal à 300 mm², et une épaisseur supérieure ou égale à 0.2 mm et/ou inférieure ou égale à 15 mm.

10. Composant horloger selon la revendication 8 ou 9, **caractérisé en ce qu'**il est transparent de sorte à permettre la lecture d'indications, notamment horaires, au travers de son épaisseur et éventuellement de sorte à permettre une charge et/ou une décharge d'une matière photoluminescente au travers de son épaisseur, et/ou **en ce qu'**il comprend un facteur de transmission (Y) supérieur ou égal à 68%.

11. Composant horloger selon la revendication précédente, **caractérisé en ce qu'**il est une glace de montre qui comprend une surface extérieure et qui comprend une surface latérale inclinée par rapport à ladite surface extérieure, d'inclinaison supérieure ou égale à 10 degrés, voire supérieure ou égale à 15 degrés, voire supérieure ou égale à 30 degrés, par rapport à la direction perpendiculaire à la surface intérieure, de sorte à moduler l'effet de coloration de la glace de montre et/ou **en ce qu'**il comprend des zones structurées en relief et/ou en retrait sur au moins une surface du composant horloger et/ou des zones structurées au sein de l'épaisseur du composant horloger.

12. Composant horloger selon la revendication précédente, **caractérisé en ce que** la surface latérale inclinée représente entre 1% et 30% de la superficie de la surface intérieure voire entre 1% et 18% de la superficie de la surface intérieure, voire entre 10% et 18% de la superficie de la surface intérieure.

13. Composant horloger selon l'une des revendications précédentes, **caractérisé en ce qu'**il comprend tout ou partie des caractéristiques suivantes :
a. Un gradient d'épaisseur de la zone de composition chimique modifiée, de sorte à moduler l'effet de coloration du composant horloger ; et/ou
b. Une discontinuité de la zone de composition chimique modifiée, notamment formant un motif.

14. Pièce d'horlogerie, **caractérisée en ce qu'**elle comprend un composant horloger selon l'une des revendications précédentes.

15. Procédé de fabrication d'un composant horloger coloré et transparent, **caractérisé en ce qu'**il comprend les étapes suivantes :
a. Mise à disposition (E0) d'un substrat initial qui comprend une surface intérieure sensiblement plane ou courbée composé principalement d'un matériau transparent ;
b. Apport (E1) d'au moins un élément chimique colorant par au moins une surface extérieure ou intérieure dudit substrat initial ;
c. Traitement thermique (E2) dudit substrat issu de l'étape d'apport (E1) comprenant au moins un élément chimique colorant pour obtenir une pièce transparente et colorée.

16. Procédé de fabrication d'un composant horloger selon la revendication précédente, **caractérisé en ce que** l'étape d'apport (E1) comprend une étape de dépôt d'un revêtement comprenant au moins un élément chimique colorant sur au moins une surface du substrat initial, notamment par dépôt physique en phase vapeur (PVD) par pulvérisation cathodique magnétron (MS) et/ou par évaporation thermique, et/ou par dépôt de couches atomiques (ALD) et/ou par dépôt chimique en phase vapeur (CVD), et/ou **en ce que** l'étape d'apport (E1) comprend une étape d'implantation ionique par recul d'au moins un élément chimique colorant.

17. Procédé de fabrication d'un composant horloger selon la revendication précédente, **caractérisé en ce que** le composant horloger est une glace de montre et **en ce que** l'étape d'apport (E1) comprend une étape de dépôt d'un revêtement d'épaisseur comprise entre 1 nm et 10 µm inclus, voire entre 1 nm et 1 µm.

18. Procédé de fabrication d'un composant horloger selon l'une des revendications 15 à 17, **caractérisé en ce que** l'étape d'apport (E1) comprend une étape de dépôt d'un revêtement et une étape préalable consistant à masquer une surface du substrat pour l'empêcher de recevoir ledit revêtement et/ou pour former un revêtement d'épaisseur variable.

19. Procédé de fabrication d'un composant horloger selon l'une des revendications 15 à 18, **caractérisé en ce que** l'étape de traitement thermique (E2) comprend un palier à une température de palier comprise entre 500°C et 1850°C, voire entre 800°C et 1400°C, voire entre 900°C et 1200°C et une durée comprise entre 0.5 et 48 heures, voire entre 0.5 heure et quatre jours.

20. Procédé de fabrication d'un composant horloger selon l'une des revendications 15 à 19, **caractérisé en ce qu'**il comprend tout ou partie des étapes supplémentaires suivantes :
a. Usinage de la pièce transparente et colorée pour former le composant horloger ; et/ou
b. Usinage d'au moins une surface de la pièce transparente et colorée pour modifier sa forme et/ou former un motif et/ou former une surface latérale inclinée par rapport à une surface extérieure du composant horloger, d'inclinaison supérieure ou égale à 10 degrés, voire supérieure ou égale à 15 degrés, voire supérieure ou égale à 30 degrés, par rapport à la direction perpendiculaire à la surface intérieure de sorte à moduler l'effet de coloration du composant horloger ; et/ou
c. Assemblage de la pièce transparente et colorée avec un autre composant horloger ; et/ou
d. Retrait d'un résidu d'élément chimique colorant d'une surface de la pièce transparente et colorée, notamment par un décapage chimique ou une action mécanique tel qu'un polissage ; et/ou
e. Gravage d'un motif au sein du composant horloger.
